# EUROPEAN PATENT APPLICATION

(11) **EP 3 376 632 A1**
(43) Date of publication of application: **19.09.2018**
(21) Application number: 18159305.4
(22) Date of filing: 28.02.2018
(51) Int. Cl.: H02J 7/00, H01M 2/10

(54) **BATTERY PACK AND METHOD OF CONNECTING THE SAME TO EXTERNAL BATTERY SYSTEMS IN PARALLEL**

(30) Priority: 17.03.2017 CN 201710161176
(71) Applicant: TTI (Macao Commercial Offshore) Limited, Macao (MO)
(72) Inventor: Li, Yong Min, Dongguan City (CN); Zhuang, Ming Jun, Dongguan City (CN); Wang, Ren Jie, Dongguan City (CN)
(74) Representative: Stevenson-Hill, Jack Patrick

(57) **Abstract**

A battery pack (20) includes a battery unit (22), a connection terminal (30) configured to electrically connect the battery pack (20) to an external device, a loop control unit (24) connected between the battery unit (22) and the connection terminal (30) and a microcontroller (26), connected to the loop control unit (24) and suitable to control the loop control unit (24). The microcontroller (26) is adapted to control the loop control unit (24) according to a voltage of the external device and a voltage of the battery unit (22), so as to adjust a direction and/or a magnitude of a current passed through the battery unit (22). The control of the current by the above microcontroller (26) is fully automated and based on the comparison of the internal and external voltages and sampling and the obtaining of the current of the battery pack (20), the user of the battery pack (20) and the electric equipment does not need to interfere with the above process, and also does not need to know the specific working process thereof. It achieves any number of battery packs (20) directly connected in parallel, and for the user, it belongs a simple operation.

## Description

### Technical Field

The present invention is related to the field of batteries, and more particularly to the field of connection and control of a plurality of battery packs.

### Background Information

With the widespread application of battery packs providing power to direct current (DC) equipment, it is often necessary to increase the capacity of the battery pack to meet the requirements of prolonged use and increased power. A common solution is to use two or more battery packs connected in parallel to form a battery system, thereby increasing the battery capacity. However, the problem with this approach is that since the internal resistance of the battery is small, the voltages of the two battery packs must be very close when the two battery packs are connected in parallel. Otherwise, if the voltage difference of the two is too large due to self-discharge effect or a difference in the state of charge itself, a large current may be generated, thereby resulting in the fuse blown in the battery pack, the failure of the protection board, and/or the overheating of the battery pack, etc.

### Summary of Invention

Accordingly, embodiments of the present invention provide an improved battery pack and a method for connecting a battery pack to an external battery system in parallel, so as to overcomes or at least mitigates the above technical problem.

A first aspect of the present invention provides a battery pack, which includes a battery unit, a connection terminal configured to electrically connect the battery pack to an external device, a loop control unit connected between the battery unit and the connection terminal; and a microcontroller connected to the loop control unit and suitable to control the loop control unit. Wherein the microcontroller is adapted to control the loop control unit according to a voltage of the external device and a voltage of the battery unit, so as to adjust a direction and/or a magnitude of a current passed through the battery unit.

Preferably, the microcontroller is adapted to compare a difference between the voltage of the external device and the voltage of the battery unit, so as to control the loop control unit.

In one specific embodiment, when the voltage of the external device is greater than the voltage of the battery unit, the microcontroller controls the loop control unit, so as to allow the battery unit to be charged by the external device.

In another specific embodiment, when the voltage of the external device is less than the voltage of the battery unit, the microcontroller controls the loop control unit, so as to allow the battery unit to provide power energy to the external device.

In one changed form of the preferred embodiment, the microcontroller measures a voltage generated on the connection terminal, so as to obtain a voltage of the external voltage.

In another changed form of the preferred embodiment, the battery pack further includes a communication bus connected to the microcontroller and a communication terminal connected to the communication bus. The communication terminal is adapted to connect to a corresponding communication interface of the external device. The microcontroller obtains a voltage of the external device through the information of the external device obtained by the communication bus.

In one specific embodiment, the battery pack further includes a current sampling unit configured between the battery unit and the connection terminal, wherein the current sampling unit is adapted to sample the current passed through the battery unit and provide a result to the microcontroller.

Another aspect of the present invention provides a battery system, which includes two or more battery packs mentioned above. The battery packs are connected to each other in parallel.

Preferably, the two or more battery packs are connected to each other through a communication bus.

Another aspect of the present invention provides a method for connecting a battery pack to an external battery system in parallel. The method includes the following steps: electrically connecting the battery pack to an external battery system; obtaining a voltage of the external battery system by the battery pack; comparing a voltage of the battery pack with the voltage of the external battery system; and adjusting a direction and/or a magnitude of a current passed through a battery unit of the battery pack by the battery pack according to a comparison result.

Preferably, the battery pack includes a microcontroller and a loop control unit controlled by the microcontroller. The loop control unit is configured between the battery unit and a connection terminal of the battery pack. The step of obtaining the voltage of the external battery system by the batter pack includes obtaining the voltage of the external battery system by the microcontroller.

In one specific embodiment, when the voltage of the external battery system is greater than the voltage of the battery pack, the microcontroller controls the loop control unit, so as to allow the battery unit to be charged by the external battery system.

In another specific embodiment, when the voltage of the external battery system is less than the voltage of the battery pack, the microcontroller controls the loop control unit, so as to allow the battery unit to provide power energy to the external battery system.

In one changed form of the preferred embodiment, the step of obtaining the voltage of the external battery system by the microcontroller includes obtaining the voltage of the external battery system by the microcontroller through a measurement of a voltage generated on the connection terminal.

In another changed form of the preferred embodiment, the battery pack includes a communication bus connected to the microcontroller and a communication terminal connected to the communication bus. The communication terminal is adapted to connect to a corresponding communication interface of the external device. The step of obtaining the voltage of the external battery system includes obtaining the voltage of the external battery system by the microcontroller through the information of the external device obtained by the communication bus.

The present invention uses the microcontroller to control the current transmission between the battery unit in the battery pack and the external device, in particular the external battery system formed of similar battery packs. By obtaining the voltage of the external battery system and comparing it with the current voltage of the battery pack, the microcontroller controls the loop control switch in the battery pack, so as to automatically adjust the magnitude and/or the direction of the current when the battery pack is connected to the external battery system in parallel. When the voltage of the connected battery pack is apparently less than the voltage of the external battery system, the microcontroller may control the current to flow to the connected battery pack from the external battery system, so as to charge the latter, and the level of the current is controlled within the average value thereof at the setting range. When the voltage of the connected battery pack is equal to or greater than the voltage of the external battery system, the microcontroller controls the loop control unit to enter a normal mode, such that the connected battery pack may provide the power to the external battery system or collectively provide the power to the connected load.

Since the control of the current by the above microcontroller is fully automated and is based on the comparison of the internal and external voltages and sampling and the obtaining of the current of the battery pack, the user of the battery pack and the electric equipment does not need to be involved in the above process, and also does not need to know the specific working process thereof. It enables any number of battery packs to be directly connected in parallel, and for the user, it is a simple operation. At the same time, this connection process does not result in voltage difference between the battery packs being too large which may result in damaging some of battery packs.

### BRIEF DESCRIPTION OF THE DRAWINGS

Further understanding of the performance and advantages of the present invention may be made with reference to the remainder of the specification and the accompanying drawings. The same components in the drawings are numbered the same. In some cases, a sub mark is placed after a reference number and a hyphen to represent one of many similar components. When referring to a reference number but does not specify a particular sub mark, it means all of these similar components.
FIG. 1 is a schematic connection view of internal components of a battery pack according to a first embodiment of the present invention.
FIG. 2 is a schematic connection view of the battery pack of FIG. 1 connected to a number of similar external battery packs in parallel.
FIG. 3 is a schematic connection view of a plurality of similar battery packs connected in parallel according to a second embodiment of the present invention.
FIG. 4 is a flowchart of a method for connecting a battery pack to an external battery system according to an embodiment of the present invention.

### DETAILED DESCRIPTION

The embodiment of the present invention uses a microcontroller to compare a voltage difference between the interior and exterior of the battery pack, thereby controlling the current passed through the battery pack. The various benefits and advantages provided by the various embodiments of the present invention will be readily apparent from the following description.

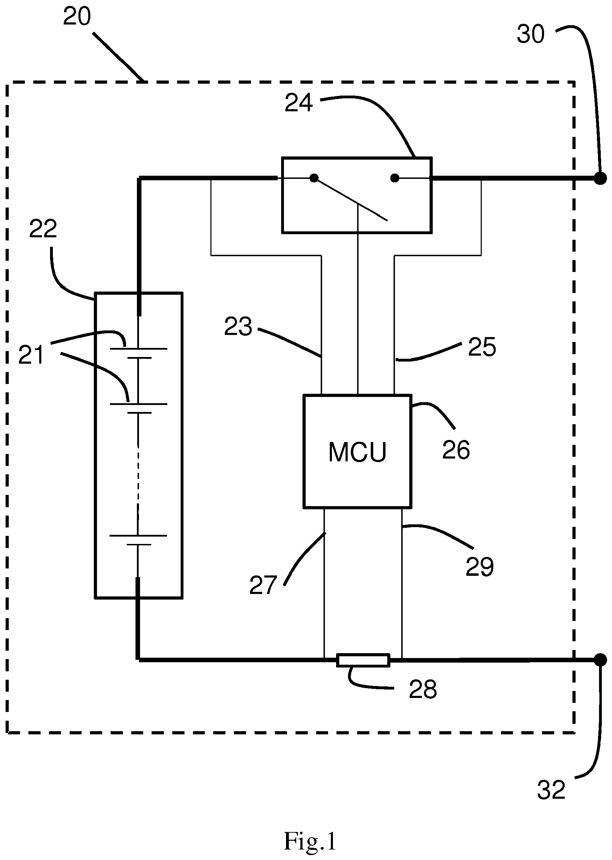

Please refer to Fig. 1. According to a first embodiment of the present invention, an interior of a single battery pack 20 includes a battery unit 22, which is formed by one battery cell 21 or more battery cells 21 connected in series. Therefore a total voltage of the battery unit 22 is equal to the sum of the individual voltage of one or more battery cells 21. The interior of the battery pack 20 further includes a microcontroller (MCU) 26, which is connected to a loop control unit 24. The loop control unit 24 is connected between an external connection terminal of the battery pack 20 and the battery unit 22. Specifically, the loop control unit 24 is connected between a positive electrode of the battery unit 22 and a positive terminal 30 of the battery pack 20, and no switch element is configured between a negative terminal 32 of the battery pack 20 and a negative electrode of the battery unit. The microcontroller 26 is further connected to a current sampling unit 28. The current sampling unit 28 is configured between the negative terminal 32 of the battery pack 20 and the negative electrode of battery unit 22, and is used to sample the current passed through the battery unit, so as to transmit a sampling result to the microcontroller 26.

It should be appreciated by those skilled in the art that the loop control unit 24 described above may be constructed individually or in combination using a variety of known elements including, but not limited to, metal oxide semiconductor field effect transistor (MOSFET), insulated gate bipolar transistor chips (IGBT), relay, variable resistor, etc. In the case of the existence of a plurality of such elements, they may be connected to each other in series, in parallel, or in first parallel and subsequent series to form a control array. Correspondingly, the microcontroller 26 may control the loop control unit 24 through a switching manner or a pulse width modulation (PWM) manner. The above content is well known to those skilled in the art and therefore is not described in detail herein.

In Fig. 1, two input terminals 23 and 25 of microcontroller 26 are directly connected to two terminals of the loop control unit 24 at the same time. Specifically, the input terminal 23 is directly connected to the positive electrode of the battery unit 22, and the input terminal 25 is connected to the positive terminal 30 of the battery pack 20. Additionally, two additional input terminals 27 and 29 of the microcontroller 26 are respectively connected to the negative electrode of the battery unit 22 and the negative terminal 32 of the battery pack. By such connection manner, the microcontroller 26 may directly measure the voltage between two terminals of the battery unit 22 and the voltage on the external connection terminal of the battery pack 20.

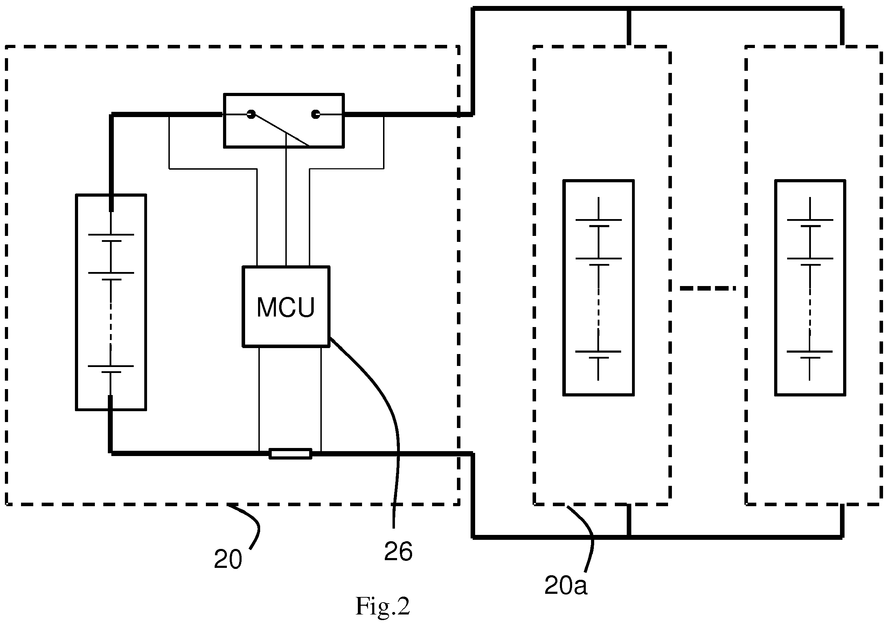

Please refer Fig. 2, which shows that some battery packs 20, 20a with similar structure are connected in parallel. Each of battery packs has the same control portion, which includes the above microcontroller and loop control unit, and a particular connection manner of them and battery unit as well as the connection terminal. These battery packs may be connected to each other in a manner well known to those skilled in the art, for example using wires, racks, metal strips, etc.

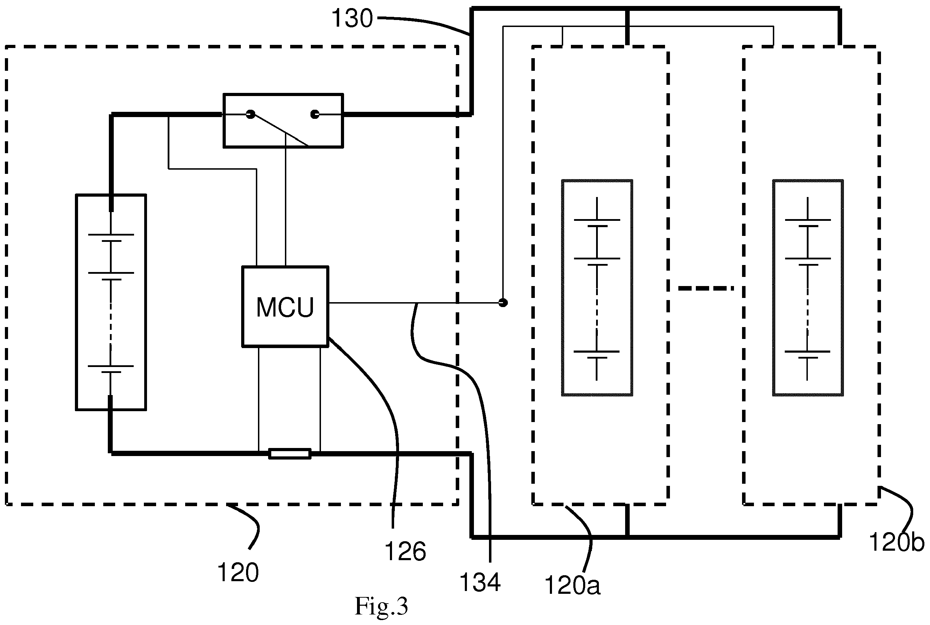

Please refer to Fig. 3. In another embodiment of the present invention, some battery packs 120, 120a with similar structure are connected in parallel. Each of the battery packs has the same control portion, which includes a microcontroller and a loop control unit, and a particular connection manner of them and battery unit as well as the connection terminal. Most of the internal components and the connection of the battery packs 120, 120a are the same as those of the battery packs 20 described above, and the description thereof is omitted. The only difference is that the microcontroller 126 of the battery pack 120 no longer has any input terminal connected to the positive terminal 130 of the battery pack 120. That is, at this time, the microcontroller 126 no longer directly measures the voltage on the external connection terminal of the battery pack 120. On the contrary, the microcontroller is connected to a communication bus 134, and the communication bus 134 is connected to a communication terminal 135 of the battery pack 120. The communication terminal 135 is similar to an external terminal of the positive terminal, which may be connected to a communication interface of an external battery system. For example, in the case of the external battery system including the battery pack 120a, the communication terminal 135 of battery pack 120 may be connected the corresponding communication terminal of the battery pack 120a.

The above communication bus and communication terminal are used to transmit various signals to transmit information and may be implemented in any manner known to those skilled in the art. For example, the modes that the communication bus may use include I2C, serial peripheral interface (SPI), differential communication, I/O signal time, universal asynchronous serial port (UART), RS-232, RS-485, controller area network (CAN), etc., and the communication bus can support two or more communication units.

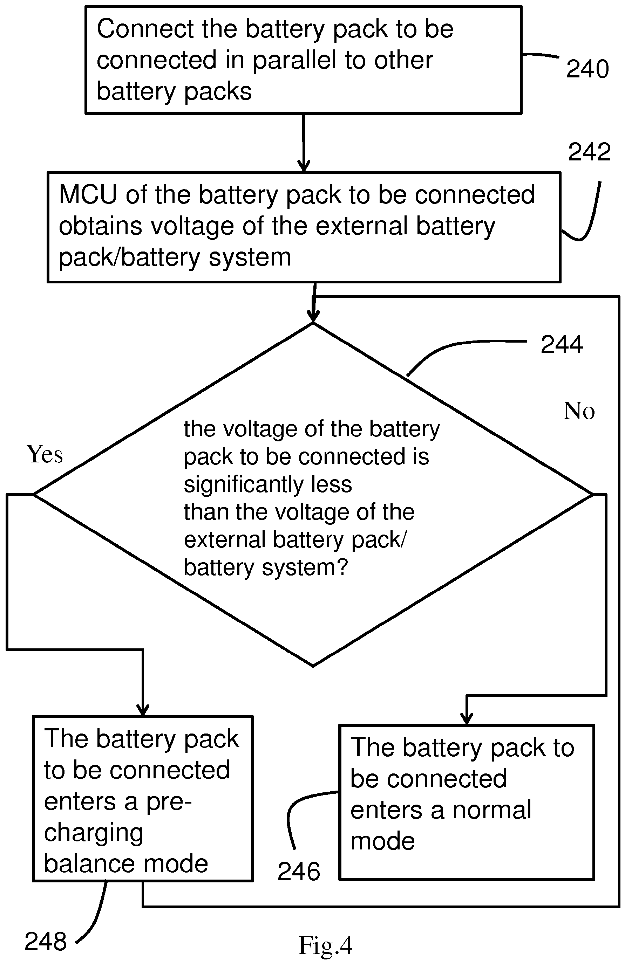

The working principle of the battery system formed of the battery pack or the battery pack shown in Figs. 1 to 3 will now be described with reference to Fig. 4. The main feature of the present invention is that when a battery pack to be connected is connected to an existing other battery pack or battery system, a microprocessor may be used to intelligently determine the voltage difference between the two parties, so as to detect and control the current and accomplish the balance between the battery packs. Firstly, in step 240, the battery pack to be connected is connected to the existing other battery pack or battery system in parallel by the user, and such connection may be performed through above various feasible means. Once the battery pack to be connected is connected, in step 242, the microcontroller of the battery pack to be connected attempts to obtain the voltage of the external battery pack or the battery system. The step 242 may optionally be accomplished through the above manner in Figs. 1 to 2 or Fig. 3. Specifically, if the battery pack is configured to directly detect the voltage on the external connection terminal thereof (as shown in Figs. 1 to 2), the microcontroller obtains the total voltage of the external battery cell through a voltage detecting line connected to the input terminal thereof. If the battery pack is configured to obtain the voltage of the external battery system through the communication bus (as shown in Fig. 3), the microcontroller receives the information of the external battery system from the communication terminal of the battery pack through the communication bus, so as to obtain the voltage of the external battery system.

Afterward, in step 244, the microcontroller of the battery pack to be connected compares the voltage of the battery pack itself, in particular the voltage of two terminals of the battery unit insides the battery pack, and the voltage of the external battery system. If the voltage of the battery pack to be connected is apparently less than the voltage of the external battery pack, in step 248, the microcontroller controls the battery pack to be connected to enter a pre-charging balance mode, and the battery pack to be connected is charged by the external battery system. In this mode, the microcontroller detects the current in real time through the current sampling unit, and controls the loop control unit, such that the average current is in s setting range. That is, the microcontroller controls the loop control unit, so as to obtain to obtain the desired current direction (inflow in the case of charge) and magnitude. In this mode, the microcontroller continuously repeats the above voltage detection and comparison action at the same time. In the step 244, if the microcontroller detects that the voltage of the battery pack to be connected is close to or greater than the voltage of the external battery pack, in step 246, the microcontroller controls the battery pack to be connected to enter a normal mode. By the operation of the loop control unit, the battery pack to be connected outputs the power, it can either charge other battery packs in an external battery system or work in parallel with other battery packs to provide the power for the final load.

Thus, after several embodiments have been described, those skilled in the art should be recognized that different modifications, additional structures, and equivalents may be used without departing from the spirit of the present invention. Correspondingly, the foregoing description should not be construed as limiting the scope of the present invention as defined in the following claims.

The names of the external battery packs and external battery systems are mentioned in the specific implementation section described above. The primary external battery system is a generic concept that may include a single or multiple battery packs (i.e., external battery packs), but may also include other types of electrical storage devices such as different types/principles of batteries, capacitors, or other energy devices. Regardless of the internal structure of the external battery system, the battery pack to be connected may obtain the total voltage of the external battery system by measuring the voltage at the end side or by using the communication bus, so as to control the charge and discharge of the battery pack to be connected.

## Claims

1. A battery pack, comprising:
a battery unit;
a connection terminal configured to electrically connect the battery pack to an external device;
a loop control unit connected between the battery unit and the connection terminal; and
a microcontroller connected to the loop control unit and adapted to control the loop control unit;
wherein the microcontroller is adapted to control the loop control unit according to a voltage of the external device and a voltage of the battery unit, so as to adjust a direction and/or a magnitude of a current passing through the battery unit.

2. The battery pack according to claim 1, wherein the microcontroller is adapted to compare a difference between the voltage of the external device and the voltage of the battery unit, so as to control the loop control unit.

3. The battery pack according to claim 2, wherein when the voltage of the external device is greater than the voltage of the battery unit, the microcontroller controls the loop control unit, so as to allow the battery unit to be charged by the external device.

4. The battery pack according to claim 2, wherein when the voltage of the external device is less than the voltage of the battery unit, the microcontroller controls the loop control unit, so as to allow the battery unit providing power energy to the external device.

5. The battery pack according to any one of claims 1 to 4, wherein the microcontroller measures a voltage generated on the connection terminal, so as to obtain a voltage of the external device.

6. The battery pack according to any one of claims 1 to 4, further comprises a communication bus connected to the microcontroller and a communication terminal connected to the communication bus, wherein the communication terminal is adapted to connect to a corresponding communication interface of the external device, and the microcontroller obtains a voltage of the external device through the information of the external device obtained by the communication bus.

7. The battery pack according to any one of claims 1 to 4, further comprises a current sampling unit configured between the battery unit and the connection terminal, wherein the current sampling unit is adapted to sample the current passed through the battery unit and provide a result to the microcontroller.

8. A battery system comprising two or more battery packs according to claim 1, wherein the battery packs are connected to each other in parallel.

9. The battery system according to claim 8, wherein the two or more battery packs are connected to each other through a communication bus.

10. A method for connecting a battery pack to an external battery system in parallel, comprising the following steps:
(a) electrically connecting the battery pack to an external battery system;
(b) obtaining a voltage of the external battery system by the battery pack;
(c) comparing a voltage of the battery pack with the voltage of the external battery system; and
(d) adjusting a direction and/or a magnitude of a current passed through a battery unit of the battery pack by the battery pack according to a comparison result.

11. The method according to claim 10, wherein the battery pack comprises a microcontroller and a loop control unit controlled by the microcontroller, the loop control unit is configured between the battery unit and a connection terminal of the battery pack, and the step of obtaining the voltage of the external battery system by the batter pack comprises obtaining the voltage of the external battery system by the microcontroller.

12. The method according to claim 11, wherein when the voltage of the external battery system is greater than the voltage of the battery pack, the microcontroller controls the loop control unit, so as to allow the battery unit to be charged by the external battery system.

13. The method according to claim 11, wherein when the voltage of the external battery system is less than the voltage of the battery pack, the microcontroller controls the loop control unit, so as to allow the battery unit to provide power energy to the external battery system.

14. The method according to any one of claims 11 to 13, wherein the step of obtaining the voltage of the external battery system by the microcontroller comprises obtaining the voltage of the external battery system by the microcontroller through a measurement of a voltage generated on the connection terminal.

15. The method according to any one of claims 11 to 13, wherein the battery pack comprises a communication bus connected to the microcontroller and a communication terminal connected to the communication bus, wherein the communication terminal is adapted to connect to a corresponding communication interface of the external device, and the step of obtaining the voltage of the external battery system comprises obtaining the voltage of the external battery system by the microcontroller through the information of the external device obtained by the communication bus.
